(19) Europäisches Patentamt

European Patent Office

Office européen des brevets

(11) **EP 0 821 475 B1**

(12) **EUROPÄISCHE PATENTSCHRIFT**

(45) Veröffentlichungstag und Bekanntmachung des Hinweises auf die Patenterteilung:
**29.11.2000  Patentblatt 2000/48**

(51) Int Cl.$^7$: **H03F 3/16**, G06G 7/60

(21) Anmeldenummer: **97111343.6**

(22) Anmeldetag: **04.07.1997**

(54) **Verstärker mit Neuron-MOS Transistoren**

Amplifier with neuron MOS transistors

Amplificateur à transistor MOS neuronal

(84) Benannte Vertragsstaaten:
**DE FR GB IT**

(30) Priorität: **25.07.1996  DE 19630112**

(43) Veröffentlichungstag der Anmeldung:
**28.01.1998  Patentblatt 1998/05**

(73) Patentinhaber: **Infineon Technologies AG**
**81541 München (DE)**

(72) Erfinder:
  • **Thewes, Roland**
    **82194 Gröbenzell (DE)**
  • **Weber, Werner**
    **80637 München (DE)**
  • **Luck, Andreas**
    **81737 München (DE)**
  • **Wohlrab, Erdmute**
    **81825 München (DE)**

  • **Schmitt-Landsiedel, Doris**
    **85521 Ottobrunn (DE)**

(74) Vertreter: **Zedlitz, Peter, Dipl.-Inf.**
    **Patentanwalt,**
    **Postfach 22 13 17**
    **80503 München (DE)**

(56) Entgegenhaltungen:
EP-A- 0 011 694          EP-A- 0 516 847
WO-A-95/31043            DE-A- 2 938 347
US-A- 4 935 702          US-A- 5 184 061
US-A- 5 444 821

  • TADASHI SHIBATA ET AL: "A FUNCTIONAL MOS TRANSISTOR FEATURING GATE-LEVEL WEIGHTED SUM AND THRESHOLD OPERATIONS" IEEE TRANSACTIONS ON ELECTRON DEVICES, Bd. 39, Nr. 6, 1.Juni 1992, Seiten 1444-1455, XP000271791

## EP 0 821 475 B1

**Beschreibung**

In vielen Analogschaltungsapplikationen, so zum Beispiel in Video- und Audioanwendungen, in der Sensorik, in Analogrechner, in bestimmten Realisierungen von (Teil-) Komponenten in Fuzzy-Schaltungen, Neuronalen Netzen usw., werden Verstärkerschaltungen und Summier-Verstärker benötigt, die ein großsignalmäßig lineares Übertragungsverhalten aufweisen. Für derartige Schaltungen werden üblicherweise Operationsverstärkerschaltungen verwendet. Diese Schaltungen sind hinsichtlich ihrer technischen Realisierung in der Mikroelektronik relativ aufwendig. Das bedeutet, daß insbesondere Anwendungen, in denen eine große Anzahl solcher Schaltungen eingesetzt werden, sich durch einen großen Platzbedarf auszeichnen. Ferner kann auch der Leistungsverbrauch der einzelnen Schaltungen in solchen Anwendungen ein Problem sein. Auch die sich in derartigen Fällen notwendigerweise ergebenden relativ langen signalführenden Leitungen zur Verbindung verschiedener Schaltungen können durch ihre Parasitärkapazität und Übersprecheinflüsse Probleme bereiten.

Aus den IEEE Transactions on Electron Devices, Vol. 39, No. 6, June 1992, Seiten 1444 bis 1455, ist der Aufbau und die Funktionsweise eines Neuron-MOS-Transistors und seine Verwendung als Verstärker bzw. Summierverstärker bekannt. Hierbei ist der Neuron-MOS-Transistor als Source-Folger geschaltet.

Die der Erfindung zugrundeliegende Aufgabe besteht nun darin, einen großsignalmäßig linearen Verstärker bzw. Summierverstärker mit präzise einstellbaren Verstärkerfaktoren anzugeben, der mit wenigen Bauelementen realisiert werden kann. Diese Aufgabe wird erfindungsgemäß durch die Merkmale des Anspruchs 1 gelöst.

Vorteilhafte Weiterbildungen ergeben sich aus den Unteransprüchen.

Durch die Erfindung ergeben sich insbesondere folgende Vorteile, daß der Platzbedarf und der Leistungsverbrauch der Schaltungen gering sind, daß der Verstärkungsfaktor über die Geometrie des Layouts des in der Schaltung zur Anwendung kommenden Neuron-MOS-Transistors exakt einstellbar ist, daß die Eingänge der Schaltungen die den jeweiligen Eingang treibende Quelle nur kapazitiv belasten, was insbesondere bei hochohmig vorliegenden Eingangssignalen von Bedeutung ist und daß die Schaltungen zeitkontinuierlich arbeiten und somit auch das in Switched-Capacitor-Schaltungen auftretende Problem des Rauschens durch Takteinkopplungen keine Rolle spielt.

Die Erfindung wird im folgenden anhand der Zeichnungen näher erläutert. Dabei zeigt

Figur 1    einen erfindungsgemäßen invertierenden Verstärker mit Neuron-MOS-Transistor,

Figur 2    eine schematische Darstellung des Übertragungsverhaltens der Schaltung aus Figur 1,

Figur 3    eine vorteilhafte Weiterbildung des Verstärkers nach Figur 1 mit zusätzlichem Eingang zur Feinjustierung des DC-Arbeitspunktes,

Figur 4    eine weitere vorteilhafte Weiterbildung des Verstärkers nach Figur 1 mit einem zusätzlichen MOS-Transistor und einer Stromquelle zur Verringerung des Ausgangswiderstandes,

Figur 5    einen invertierenden Neuron-MOS-Transistor-Verstärker mit k Eingängen auf der Basis eines Verstärkers nach Figur 1 und

Figur 6    einen entsprechenden allgemeinen Summierverstärker mit n invertierenden und k nichtinvertierenden Eingängen.

Für die Beschreibung werden folgende Konventionen vereinbart: Das Massepotential GND beträgt 0 Volt und die Schaltungen werden mit einer symmetrischen Versorgungsspannung bezüglich GND-Potential betrieben. Die positive Versorgungsspannung wird mit VDD bezeichnet, die negative mit VSS. Aufgrund der Symmetrie der Versorgungsspannungen gilt VDD = -VSS. Für den Neuron-MOSFET wird das bei der Veröffentlichung von Shibata gezeigte Symbol verwendet. In diesem Bild sind die Eingänge $IN_1 ... IN_n$ zu erkennen, die wiederum mit den Koppel-Gates $GK_1 ... GK_n$ verbunden sind, ferner das Floating-Gate FG, der Kanalbereich CH und die Anschlüsse Source (S) und Drain (D).

Es werden ferner folgende Definitionen vereinbart: Die Kapazität zwischen einem Koppel-Gate $GK_i$ und dem Floating-Gate FG wird mit $C_{IN,i}$ bezeichnet. Die Kapazität zwischen dem Floating-Gate FG und dem Kanalbereich CH einschließlich der Source-Drain-Überlappkapazitäten wird mit $C_{FG}$ bezeichnet. Der Kapazitätsbelag dieser Kapazität in y-Richtung, wobei der y-Vektor parallel zum Stromfluß im Kanalbereich des Transistors liegt, wird mit $C'_{FG}$ bezeichnet, es gilt:

2

$$C'_{FG} = \frac{\partial C_{FC}}{\partial y} \qquad \text{Dimension: F/m} \qquad (1)$$

Unter der Wichtung $w_i$ eines Eingangs wird das Verhältnis aus Koppelkapazität $C_{IN,i}$ und der Summe aller Kapazitäten $C_{ges}$, deren eine Elektrode das Floating-Gate FG darstellt, verstanden, das heißt, es gilt:

$$w_i = \frac{C_{IN,i}}{C_{ges}} = \frac{C_{IN,i}}{C_{FG} + \sum\limits_{j=1}^{n} C_{IN,j}} \qquad (2)$$

Da die Koppelkapazität $C_{IN,i}$ eines Eingangs $IN_i$ proportional zur Fläche des Koppel-Gates $GK_i$ ist, läßt sich die Wichtung $w_i$ eines Eingangs über die Fläche des entsprechenden Koppel-Gates einstellen. Insbesondere folgt aus Gl. (2), daß das Verhältnis der Wichtungen zweier Eingänge $IN_i$ und $IN_j$ mit $i \neq j$ sich über das Flächenverhältnis der jeweiligen Koppel-Gates einstellen läßt, das heißt, es gilt:

$$\frac{w_i}{w_j} = \frac{C_{IN,i}}{C_{IN,j}} = \frac{\text{Fläche (Koppel-Gate } GK_i)}{\text{Fläche (Koppel-Gate } GK_j)}$$

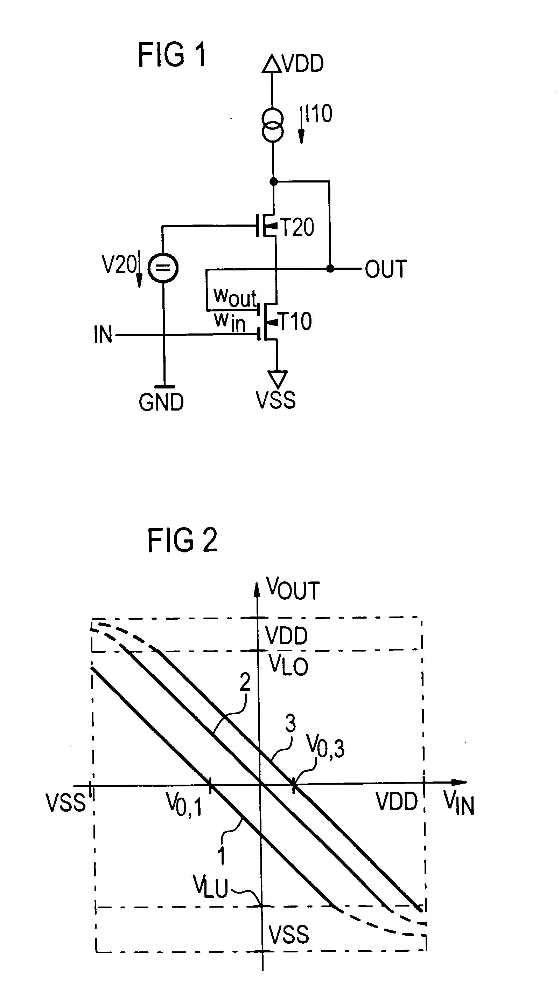

Das Grundprinzip aller im folgenden gezeigten Schaltungen beruht auf dem in Figur 1 gezeigten invertierenden Verstärker mit einem Eingang IN und einem Ausgang OUT. Die Schaltung ist aufgebaut aus dem Neuron-MOSFET T10, einem weiteren n-MOSFET T20, einer Spannungsquelle V20 und einer Stromquelle I10. Diese Stromquelle kann zum Beispiel durch den Ausgang eines p-MOS-Stromspiegels realisiert werden, wozu je nach Aufbau der Stromspiegelschaltung ein oder zwei p-MOS-Transistoren pro Stromquellen-Ausgang benötigt werden. Der Eingang IN der Schaltung ist verbunden mit einem Koppel-Gate des Neuron-MOS-Transistors T10 mit dem Gewicht $w_{IN}$. Der Ausgang OUT der Schaltung ist verbunden mit einem weiteren Koppel-Gate von T10 mit dem Gewicht $w_{OUT}$.

Mittels der Stromquelle I10 wird ein konstanter Querstrom durch die beiden Transistoren T10 und T20 eingeprägt. Ans Gate von T20 wird über die Spannungsquelle V20 eine konstante Vorspannung im Bereich von ca. <=0 Volt angelegt. Wenn nun das Drainpotential von T20, welches gleichzeitig das Knotenpotential des Ausgangs OUT der Schaltung ist, größer als V20-$V_{th,T20}$ ist, wobei $V_{th,T20}$ für die Schwellenspannung von T20 steht, liegt der Arbeitspunkt von T20 im Sättigungsbereich. Wird zunächst davon ausgegangen, daß der von der Stromquelle I10 gelieferte Strom unabhängig von der Spannung am Knoten OUT der Schaltung ist, so stellt der Bereich aller Ausgangsspannungen, bei denen der Arbeitspunkt von T20 im Sättigungsbereich liegt, den nominalen Betriebsfall der Schaltung dar. Bei einer adäquaten Wahl von V20 ist ein sehr weiter Ausgangsspannungsbereich möglich.

Da T20 im nominalen Betriebsfall in Sättigung arbeitet, stellt sich eine konstante Gate-Source-Spannung an T20 ein. Da wiederum das Gatepotential von T20 über die Spannungsquelle V20 vorgegeben ist, ergibt sich auch ein konstantes Sourcepotential von T20 und somit auch ein konstantes Drainpotential von T10.

Um den von der Stromquelle I10 eingeprägten Strom zu führen, muß sich auf dem Floating-Gate von T10 ein definierter Floating-Gate-Pegel $V_{FG}$ einstellen. Der Floating-Gate-Pegel ergibt sich über den kapazitiven Spannungsteiler aller Kapazitäten, dessen eine Elektrode das Floating-Gate selbst darstellt. Wenn man ferner noch eine mögliche prozeßbedingte Aufladung des Floating-Gates auf ein Potential $V_{QP}$ mit berücksichtigt, kann der Floating-Gate-Pegel $V_{FG}$ durch folgende Gleichung in allgemeiner Form beschrieben werden als:

$$V_{FG} = V_{QP} + w_{IN} \times V_{IN} + w_{OUT} \times V_{OUT} + \int\limits_{Source(T10)}^{Drain(T10)} \frac{C'_{FG}(y)}{C_{ges}} V(y)\,dy \qquad (3)$$

Das Integral in dieser Gleichung stellt den Beitrag über $C_{FG}$ dar, der sich aus der Integration über den Kapazitätsbelag $C'_{FG}(y)$ des Kanalbereichs und das Kanalpotential $V(y)$ des Neuron-MOSEFTs T10 ergibt. Da Drain- und Sourcepotential von T10 Konstanten sind und auch die lokale Flächenladungsdichte im Kanalbereich aufgrund des festen eingeprägten Stromes konstant ist, können sich die Parameter $C'_{FG}(y)$ und $V(y)$ während des Betriebes nicht ändern. Das heißt, die aktuellen Werte von Ein- und Ausgangsspannung $V_{IN}$ bzw. $V_{OUT}$ haben keinen Einfluß auf den Wert dieser Parameter. Also stellt das Integral eine Konstante dar, deren Wert im folgenden mit $V_{CH}$ bezeichnet wird. Gleichung (3) läßt sich damit umformen zu:

$$V_{FG} = V_{QP} + w_{IN} \times V_{IN} + w_{OUT} \times V_{OUT} + V_{CH} \qquad (4)$$

Auflösung dieser Gleichung nach $V_{OUT}$ und Zusammenfassung der Konstanten $V_{FG}$, $V_{QP}$ und $V_{CH}$ zu einer Konstanten $V_O=V_{FG}-V_{QP}-V_{CH}$ ergibt:

$$V_{OUT} = \frac{1}{w_{OUT}} \times V_0 - \frac{w_{IN}}{w_{OUT}} \times V_{IN} \qquad (5)$$

Für jede, auch für eine großsignalmäßige Änderung $\Delta V_{OUT}$ der Ausgangsspannung $V_{OUT}$ als Funktion der großsignalmäßigen Änderung $\Delta V_{IN}$ der Eingangsspannung $V_{IN}$ gilt also:

$$\Delta V_{OUT} = -v \times \Delta V_{IN} \qquad (6a)$$

mit

$$v = \frac{w_{IN}}{w_{OUT}} \qquad (6b)$$

Figur 2 zeigt eine schematische Darstellung des Übertragungsverhaltens gemäß Gleichung (5) für verschiedene Werte $V_0$ bei $w_{IN} = w_{OUT}$, wobei eine Übertragungskennlinie 1 mit einer negativen Nullpunktsspannung V01, eine Übertragungskennlinie 2 mit einer Nullpunktsspannung V02 =0 und eine übertragungskennlinie 3 mit einer positiven Nullpunktsspannung eingezeichnet sind. Der Aussteuerungsbereich, in welchem die Schaltung linear arbeitet, ist durch die Spannungen $V_{LO}$ und $V_{LU}$ eingegrenzt. Die untere Aussteuerungsgrenze $V_{LU}$ hat die Ursache darin, daß unterhalb dieses Wertes der Ausgangsspannung $V_{OUT}$, die gleichzeitig das Drainpotential von T20 bildet, der Arbeitspunkt von T20 aufgrund der nicht mehr ausreichend großen Drain-Source-Spannung aus dem Sättigungsbereich ins Triodengebiet wandert. Sofern der Arbeitspunkt von T20 jedoch im Triodengebiet liegt, ist die Sourcespannung von T20 und damit auch die Drainspannung von T10 eine Funktion der Drainspannung von T20, das heißt der Ausgangsspannung $V_{OUT}$. Gemäß der Argumentation im Zusammenhang mit den Gleichungen (3) ... (6b) ist eine Voraussetzung für das gewünschte lineare Übertragungsverhalten jedoch die Konstanz des Drainpotentials von T10, was für Ausgangsspannungen $V_{OUT}<=V_{LU}$ nicht mehr erfüllt ist.

Eine weitere Voraussetzung für das lineare Übertragungsverhalten ist die Konstanz des über die Stromquelle I10 eingeprägten Stromes. Reale Stromquellen können einen konstanten Strom jedoch nur dann liefern, sofern der Spannungsabfall über der Stromquelle einen bestimmten Wert nicht unterschreitet. Bei steigenden Werten $V_{OUT}$ der Ausgangsspannung nimmt der Spannungsabfall VDD-$V_{OUT}$ über der Stromquelle I10 ab, bis ein bestimmter Grenzwert dieses Spannungsabfalls erreicht ist, bei der der von der Stromquelle gelieferte Strom von seinem Sollwert abzuweichen beginnt. Gemäß der schematischen Darstellung in Figur 2 beträgt der Wert dieses Spannungsabfalls VDD-$V_{LO}$.

Eine geeignete Dimensionierung der Transistoren T10 und T20 und der Stromquelle I10 und eine geeignete Wahl des eingeprägten Stromes und der Spannung V20 erlauben jedoch, die Größe des linearen Aussteuerbereiches dieser Schaltung so zu gestalten, daß die Grenzen $V_{LO}$ und $V_{LU}$ nahe bei den jeweiligen Betriebsspannungen VDD und VSS liegen.

Bevorzugterweise kann der Gleichspannungsanteil $V_0$ der Übertragungsfunktion gemäß Gleichung (5) auf 0 Volt oder einen besonderen, wohldefinierten Wert eingestellt sein. Dazu bestehen zwei Möglichkeiten:

1. Da die Flating-Gate-Spannung $V_{FG}$ von T10 zum einen eine Funktion des eingeprägten Querstromes ist und zum anderen gemäß der Beziehung $V_0=V_{FG}-V_{QP}-V_{CH}$ direkt auf den Wert $V_0$ der Übertragungsfunktion gemäß Gleichung (5) einwirkt, besteht die Möglichkeit, durch geeignete Wahl des Stromes I10 den gewünschten Wert von $V_0$ einzustellen.

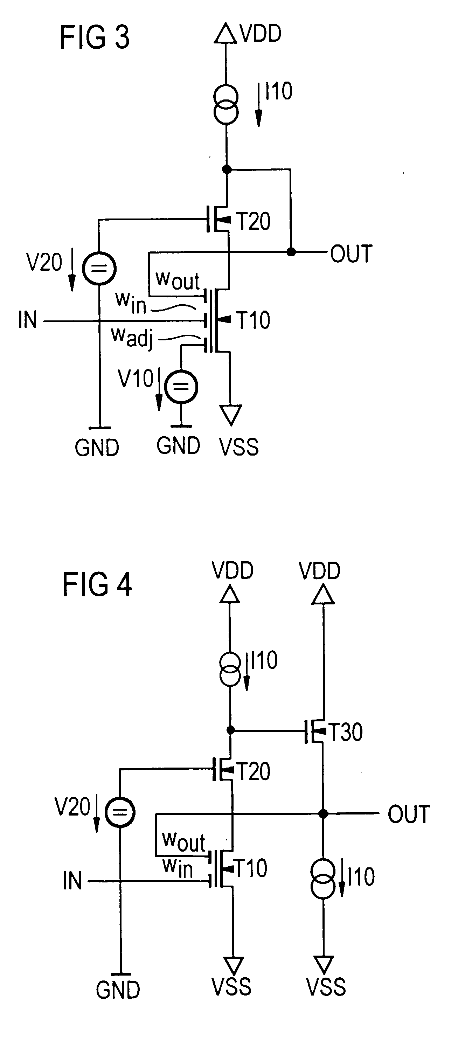

2. Wenn der Neuron-MOS-Transistor aus Figur 1 um ein weiteres Koppel-Gate erweitert wird, so daß sich die in Figur 3 skizzierte Schaltung ergibt, kann dieses weitere Koppel-Gate mit der Gewichtung $w_{adj}$ für den Abgleich der Spannung $V_0$ benutzt werden. Das bedeutet, daß an dieses Koppel-Gate im Betriebsfall eine konstante Gleichspannung V10 angelegt werden muß, deren Wert bei Vorgabe von $V_0$ abgeglichen werden kann.

Der Ausgangswiderstand $r_{OUT,ges}$ der Schaltung gemäß Figur 1 bzw. Figur 3 berechnet sich aus dem Ausgangswiderstand $r_{OUT,I10}$ der Stromquelle I10 und dem differentiellen Ausgangswiderstand $r_{DS,T20}$ des Transistors T20 näherungsweise zu:

$$r_{OUT,ges} = \frac{r_{OUT,I10} \times r_{DS,T20}}{r_{OUT,I10} + r_{DS,T20}} \tag{7}$$

Daraus ergibt sich ein relativ großer Ausgangwiderstand. In vielen Fällen ist es wünschenswert, über eine Schaltung mit geringerem Ausgangswiderstand zu verfügen. Eine signifikante Verminderung des Ausgangswiderstandes wird durch Hinzunahme eines weiteren Transistors T30 sowie einer weiteren Stromquelle I30 gemäß Figur 4 erreicht. T30 arbeitet in dieser Schaltung als Sourcefolger. Den Ausgang der gesamten Schaltung stellt der Sourceknoten dieses Transistors dar, welcher auch hier analog zu den Schaltungen in Figur 1 und 3 mit dem Koppel-Gate mit der Wichtung $w_{OUT}$ des Neuron-MOS-Transistors T10 verbunden ist. Das Gate von T30 wird an den Drainknoten von T20 angeschlossen. Die Übertragungsfunktion dieser Schaltung wird durch die Gleichungen (3) ... (6) beschrieben.

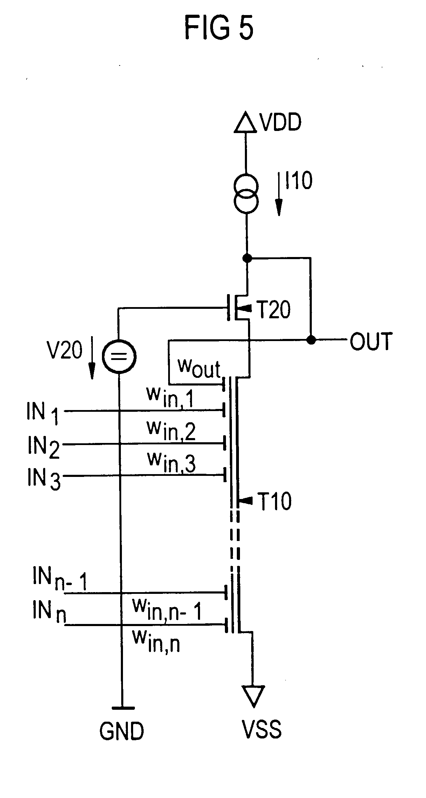

Eine Verallgemeinerung der Schaltung aus Figur 1 ist in Figur 5 dargestellt. Es handelt sich dabei um einen Verstärker, der die Eingangssignale der Eingänge $IN_1$ ... $IN_n$ mit der jeweiligen Wichtung aufaddiert und deren Summe invertierend verstärkt an seinem Ausgang zur Verfügung stellt. In formaler Schreibweise lautet die Übertragungsfunktion:

$$V_{OUT} = \frac{1}{w_{OUT}} \times V_0 - \sum_{i=1}^{n} v_i \times V_{IN,i} \qquad (8a) \qquad \text{mit } v_i = \frac{w_{IN,i}}{w_{OUT}} \qquad (8b)$$

Die oben beschriebenen Maßnahmen zur Einstellung der Spannung $V_0$ bzw. zur Erhöhung des Ausgangswiderstandes können auch bei dieser Schaltung in gleicher Weise zu Anwendung kommen.

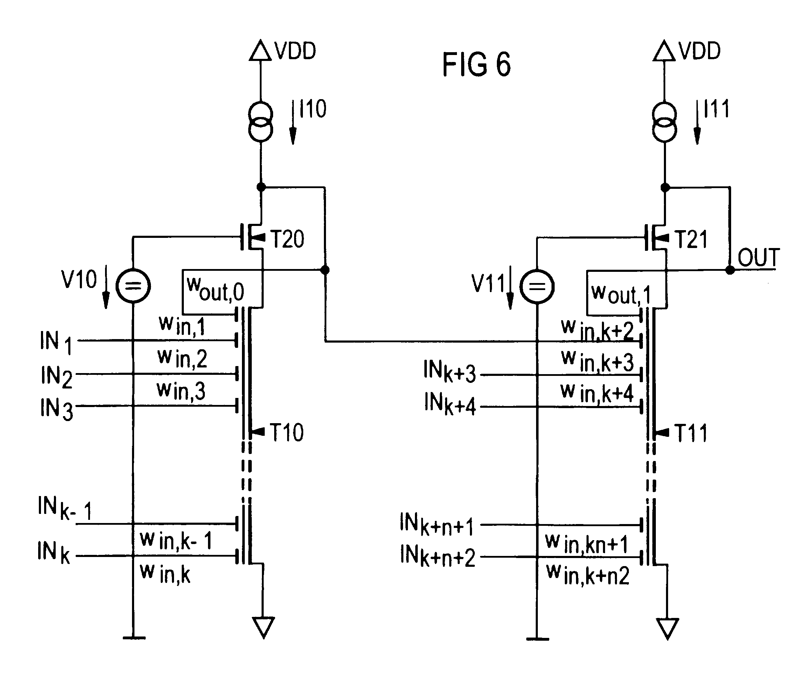

In Figur 6 wird eine Schaltung gezeigt, die einen Verstärker bzw. Summierer mit k nichtinvertierenden und n invertierenden Eingängen darstellt. Diese Schaltung ergibt sich aus Kaskadierung zweier Schaltungen gemäß Figur 5. Dabei ist zu berücksichtigen, daß der Neuron-MOSFET T11 bei n freien Signaleingängen n+2 Koppel-Gates enthalten muß, wobei eines der Rückführung des Ausgangssignales der gesamten Schaltung und eines der Einspeisung des Ausgangssignales der ersten Stufe um T10 dient. Im Vergleich: Der Transistor T10 muß bei k freien Eingängen nur k+1 Koppel-Gates aufweisen. Die Übertragungsfunktion dieser Schaltung lautet:

$$V_{OUT} = \frac{1}{w_{OUT}(T11)} \times V_0(T11) - \sum_{j=k+3}^{k+n+2} v_j \times V_{IN,j} + v_{k+2} \times \left[ -\frac{1}{w_{OUT}(T11)} \times V_0(T10) + \sum_{i=1}^{k} v_i V_{IN,i} \right]$$

$$(9a)$$

mit

$$v_i = \frac{w_{IN,i}}{w_{OUT}(T10)} \qquad \text{fur } i = 1...k \tag{9b}$$

und

$$v_j = \frac{w_{IN,j}}{W_{OUT}(T11)} \qquad \text{für } j = k+3 \ldots k+n+2 \qquad\qquad (9c)$$

In diesen Gleichungen muß selbstverständlich für die Parameter $w_{OUT}$ und $V_0$ unterschieden werden, auf welchen der beiden Neuron-MOS-Transistoren sie sich beziehen. Dies ist durch die Nennung des Transistors in der Klammer hinter dem jeweiligen Parameter geschehen.

Die oben beschriebenen Maßnahmen zur Einstellung der Spannung $V_0$ bzw. zur Erhöhung des Ausgangswiderstandes für jede der beiden Verstärkerstufen um T10 bzw. um T11 können auch bei dieser Schaltung in gleicher Weise wie im Zusammenhang mit Figur 3 bzw. Figur 4 erläutert zur Anwendung kommen.

Selbstverständlich ist es möglich, alle gezeigten Schaltungen auch komplementär zu den gezeigten Ausführungsbeispielen aufzubauen. In diesem Falle müßten die Anschlüsse VDD und VSS vertauscht werden, die Transistoren T10, T11, T20 und T30 müßten als p-Kanal-Transistoren ausgeführt werden.

## Patentansprüche

1. Verstärker mit Neuron-MOS-Transistor,

   bei dem ein erstes Gate des Neuron-MOS-Transistors mit einem Verstärkereingang (IN) und ein zweites Gate des Neuron-MOS-Transistors mit einem Verstärkerausgang (OUT) verbunden sind,
   bei dem ein erster Anschluß einer Einrichtung (T20,V20) zur Konstanthaltung der Drainspannung des Neuron-MOS-Transistors (T10) mit einer Konstantstromquelle (I10) verbunden ist und den Verstärkerausgang (OUT) bildet,
   bei dem ein zweiter Anschluß der Einrichtung zur Konstanthaltung der Drainspannung mit einem ersten Anschluß des Neuron-MOS-Transistors (T10) verbunden ist und
   bei dem ein zweiter Anschluß des Neuron-MOS-Transistors (T10) mit einem festen Potential (VSS) verbunden ist,

2. Verstärker nach Anspruch 1,

   bei dem die Einrichtung zur Konstanthaltung der Drainspannung des Neuron-MOS-Transistors einen MOS-Transistor (T20) aufweist, dessen erster Anschluß über die Konstantstromquelle (I10) mit einer Versorgungsspannung (VDD) verbunden ist,
   bei dem der erste Anschluß des Neuron-MOS-Transistors (T10) mit einem zweiten Anschluß des MOS-Transistors (T20) verbunden ist und der zweite Anschluß des Neuron-MOS-Transistors (T10) mit Bezugspotential (VSS) verbunden sind und
   bei dem ein Gate des MOS-Transistors (T20) mit einer Spannungsquelle (V20) beschaltet ist.

3. Verstärker nach Anspruch 1 oder 2,

   bei dem das erste Gate eine Eingangswichtung ($w_{in}$) und das zweite Gate eine Ausgangswichtung ($w_{out}$) bewirken, wobei die Wichtungen über die Flächen der Gates erfolgen, und
   bei dem der Verstärkungsfaktor durch Wahl des Wichtungsverhältnisses aus Eingangswichtung zu Ausgangswichtung einstellbar ist.

4. Verstärker nach einem der Ansprüche 1 bis 3,

   bei dem der Neuron-MOS-Transistor ein drittes Gate mit einer Abstimmungswichtung ($W_{adj}$) aufweist, wobei die Abstimmungswichtung über die Fläche des dritten Gate erfolgt, und
   bei dem das dritte Gate mit einer Abstimmspannung (V10) verbunden ist, um den Gleichspannungs-Arbeitspunkt einzustellen.

5. Verstärker nach einem der Ansprüche 2 bis 4

   bei dem der erste Anschluß des ersten MOS-Transistors (T20) mit dem Gate eines zweiten MOS-Transistors (T30) verbunden ist, dessen erster Anschluß mit der Versorgungsspannung beschaltet ist und dessen zweiter Anschluß über eine weitere Stromquelle (I30) mit Bezugspotential verbunden ist, und

bei dem anstelle des ersten Anschlusses des ersten MOS-Transistors (T20) der zweite Anschluß des zweiten MOS-Transistors (T30) den Verstärkerausgang (OUT) bildet.

6. Verwendung eines Verstärkers nach einem der Ansprüche 1, 2, 4 und 5 als invertierender Summierstärker, bei der der Neuron-MOS-Transistor mindestens ein weiteres Gate mit einer jeweiligen weiteren Eingangswichtung ($w_{in,2}$.. $w_{in,n}$) aufweist, das mit einem jeweiligen weiteren Verstärkereingang ($IN_2$ .. $IN_n$) verbunden ist.

7. Verwendung nach Anspruch 6, bei der der jeweilige Verstärkungsfaktor ($v_i$) durch Wahl des Wichtungsverhältnisses der jeweiligen Eingangswichtung ($w_{in,i}$) zur Ausgangswichtung ($w_{out}$) einstellbar ist.

8. Verwendung einer Reihenschaltung zweier Verstärker nach einem der Ansprüche 1 bis 7 als universeller Summierverstärker,

   bei der k Eingänge eines ersten der beiden Verstärker nicht-invertierende Eingänge des Summierverstärkers und n Eingänge eines zweiten der beiden Verstärker invertierende Eingänge des universellen Summierverstärkers bilden,
   bei der der Verstärkerausgang des ersten Verstärkers bzw. invertierenden Summierverstärkers mit einem weiteren zusätzlichen Gate des Neurontransistors (T11) des zweiten Verstärkers verbunden ist und
   bei der der Verstärkerausgang des zweiten Verstärkers bzw. invertierenden Summierverstärkers den Verstärkerausgang (OUT) des universellen Summierverstärkers bildet.

9. Verwendung nach Anspruch 8, bei der die Verstärkungsfaktoren für die nichtinvertierenden Eingänge (IN1..INk) sowohl durch Wahl des Wichtungsverhältnisses der Eingangswichtungen ($w_{in,i}$) zur Ausgangswichtung ($w_{out}$) beim Neuron-MOS-Transistor des ersten Verstärkers bzw. invertierenden Summierverstärkers als auch durch Wahl des Wichtungsverhältnisses der Eingangswichtung ($w_{in,k+2}$) des weiteren zusätzlichen Gates zur Ausgangswichtung ($w_{out}$) beim Neuron-MOS-Transistors des zweiten Verstärkers bzw. invertierenden Summierverstärkers einstellbar sind.

**Claims**

1. Amplifier with a neuron MOS transistor, in the case of which a first gate of the neuron MOS transistor is connected to an amplifier input (IN) and a second gate of the neuron MOS transistor is connected to an amplifier output (OUT), in the case of which a first terminal of a device (T20, V20) for keeping the drain voltage of the neuron MOS transistor (T10) constant is connected to a constant-current source (I10) and forms the amplifier output (OUT), in the case of which a second terminal of the device for keeping the drain voltage constant is connected to a first terminal of the neuron MOS transistor (T10), and in the case of which a second terminal of the neuron MOS transistor (T10) is connected to a fixed potential (VSS).

2. Amplifier according to Claim 1, in the case of which the device for keeping the drain voltage of the neuron MOS transistor constant has an MOS transistor (T20) whose first terminal is connected to a supply voltage (VDD) via the constant-current source (I10), in the case of which the first terminal of the neuron MOS transistor (T10) is connected to a second terminal of the MOS transistor (T20), and the second terminal of the neuron MOS transistor (T10) is connected to reference potential (VSS), and in the case of which a gate of the MOS transistor (T20) is connected to a voltage source (V20).

3. Amplifier according to Claim 1 or 2, in the case of which the first gate effects input weighting ($w_{in}$), and the second gate effects output weighting ($w_{out}$), the weightings being performed via the areas of the gates, and in the case of which the gain can be adjusted by selecting the weighting ratio of input weighting to output weighting.

4. Amplifier according to one of Claims 1 to 3, in the case of which the neuron MOS transistor has a third gate with a tuning weighting ($w_{adj}$), the tuning weighting being performed via the area of the third gate, and in the case of which the third gate is connected to a tuning voltage (V10) in order to adjust the DC voltage operating point.

5. Amplifier according to one of Claims 2 to 4, in the case of which the first terminal of the first MOS transistor (T20) is connected to the gate of a second MOS transistor (T30) whose first terminal is connected to the supply voltage and whose second terminal is connected to reference potential via a further current source (I30), and in the case of which instead of the first terminal of the first MOS transistor (T20), the second terminal of the second MOS transistor (T30) forms the amplifier output (OUT).

6. Use of an amplifier according to one of Claims 1, 2, 4 and 5 as an inverting summing amplifier, in the case of which the neuron MOS transistor has at least one further gate with a respective further input weighting ($w_{in,2}..w_{in,n}$), which is connected to a respective further amplifier input ($IN_2 .. IN_n$).

7. Use according to Claim 6, in the case of which the respective gain ($v_i$) can be adjusted by selecting the weighting ratio of the respective input weighting ($w_{in,i}$) to the output weighting ($w_{out}$).

8. Use of a series circuit of two amplifiers according to one of Claims 1 to 7 as a universal summing amplifier, in the case of which k inputs of a first of the two amplifiers form non-inverting inputs of the summing amplifier, and n inputs of a second of the two amplifiers form inverting inputs of the universal summing amplifier, in the case of which the amplifier output of the first amplifier or inverting summing amplifier is connected to a further additional gate of the neuron transistor (T11) of the second amplifier, and in the case of which the amplifier output of the second amplifier or inverting summing amplifier forms the amplifier output (OUT) of the universal summing amplifier.

9. Use according to Claim 8, in the case of which the gain for the non-inverting inputs (INl..INk) can be adjusted both by selecting the weighting ratio of the input weightings ($w_{in,i}$) to the output weighting ($w_{out}$) in the case of the neuron MOS transistor of the first amplifier or inverting summing amplifier, and by selecting the weighting ratio of the input weighting ($w_{in,k+2}$) of the further additional gate to the output weighting ($w_{out}$) in the case of the neuron MOS transistor of the second amplifier or inverting summing amplifier.

**Revendications**

1. Amplificateur à transistor MOS neuronal,

   dans lequel une première grille du transistor MOS neuronal est reliée à une entrée (IN) d'amplificateur et une deuxième grille du transistor MOS neuronal est reliée à une sortie (OUT) d'amplificateur,
   dans lequel une première borne d'un dispositif (T20, V20) servant à maintenir constante la tension de drain du transistor (T10) MOS neuronal est reliée à une source (110) de courant constant et forme la sortie (OUT) d'amplificateur,
   dans lequel une deuxième borne du dispositif pour maintenir constante la tension de drain est reliée à une première borne du transistor (T10) MOS neuronal et
   dans lequel une deuxième borne du transistor (T10) MOS neuronal est reliée à un potentiel (VSS) fixe.

2. Amplificateur suivant la revendication 1, dans lequel le dispositif pour maintenir constante la tension de drain du transistor MOS neuronal comporte un transistor (T20) MOS dont la première borne est reliée par l'intermédiaire de la source (110) de courant constant à une tension (VDD) d'alimentation,

   dans lequel la première borne du transistor (T10) MOS neuronal est reliée à une deuxième borne du transistor (T20) MOS et la deuxième borne du transistor (T10) MOS neuronal est reliée au potentiel (VSS) de référence et
   dans lequel une grille du transistor (T20) MOS est reliée à une source (V20) de tension.

3. Amplificateur suivant la revendication 1 ou 2, dans lequel la première grille provoque une pondération ($w_{in}$) d'entrée et la deuxième grille provoque une pondération ($w_{out}$) de sortie, les pondérations s'effectuant en fonction des surfaces des grilles, et

   dans lequel le facteur d'amplification peut être réglé en choisissant le rapport de la pondération d'entrée à la pondération de sortie.

4. Amplificateur suivant l'une des revendications 1 à 3,

   dans lequel le transistor MOS neuronal comporte une troisième grille ayant une pondération ($W_{adj}$) d'adaptation, la pondération d'adaptation s'effectuant en fonction de la surface de la troisième grille, et
   dans lequel la troisième grille est reliée à une tension (V10) d'adaptation afin de régler le point de fonctionnement de la tension continue.

**5.** Amplificateur suivant l'une des revendications 2 à 4,

dans lequel la première borne du premier transistor (T20) MOS est reliée à la grille d'un deuxième transistor (T30) MOS dont la première borne est reliée à la tension d'alimentation et dont la deuxième borne est reliée par l'intermédiaire d'une source (130) de courant supplémentaire au potentiel de référence et
dans lequel la deuxième borne du deuxième transistor (T30) MOS forme la sortie (OUT) d'amplificateur au lieu de la première borne du premier transistor (T20) MOS.

**6.** Utilisation d'un amplificateur suivant l'une des revendications 1, 2, 4 et 5 comme amplificateur additif inverseur, dans laquelle le transistor MOS neuronal comporte au moins une grille supplémentaire à pondération ($w_{in,2}$... $w_{in,n}$) d'entrée associée supplémentaire qui est reliée à une entrée ($IN_2I...N_n$) d'amplificateur supplémentaire associé.

**7.** Utilisation suivant la revendication 6, dans laquelle le facteur ($v_i$) d'amplification associée peut être réglé en choisissant le rapport de la pondération ($w_{in,i}$) d'entrée à la pondération ($w_{out}$) de sortie.

**8.** Utilisation d'un circuit série de deux amplificateurs suivant l'une des revendications 1 à 7 comme amplificateur additif universel,

dans laquelle k entrées d'un premier des deux amplificateurs forment des entrées non inverseuses de l'amplificateur additif et n entrées d'un deuxième des deux amplificateurs forment des entrées inverseuses de l'amplificateur additif universel,
dans laquelle la sortie d'amplificateur du premier amplificateur ou amplificateur additif inverseur est reliée à une autre grille supplémentaire du transistor (T11) neuronal du deuxième amplificateur et
dans laquelle la sortie d'amplificateur du deuxième amplificateur ou amplificateur additif inverseur forme la sortie (OUT) d'amplificateur de l'amplificateur additif universel).

**9.** Utilisation suivant la revendication 8, dans laquelle les facteurs d'amplification pour les entrées (IN1...INk) non inverseuses peuvent être réglées tant par le choix du rapport des pondérations ($w_{in,i}$) d'entrée à la pondération ($w_{out}$) de sortie pour le transistor MOS neuronal du premier amplificateur ou amplificateur additif inverseur que par le choix du rapport de la pondération ($w_{in,k+2}$) d'entrée de l'autre grille supplémentaire à la pondération ($w_{out}$) de sortie pour le transistor MOS neuronal du deuxième amplificateur ou amplificateur additif inverseur.

FIG 1

FIG 2

FIG 3

FIG 4

# FIG 5

FIG 6